# EUROPEAN PATENT SPECIFICATION

(11) **EP 1 446 911 B1**
(45) Date of publication and mention of the grant of the patent: **21.06.2006**
(21) Application number: 02751575.8
(22) Date of filing: 02.08.2002
(51) Int. Cl.: H04L 7/033, H03L 7/07

(54) **DATA AND CLOCK RECOVERY CIRCUIT AND AN ARRANGEMENT COMPRISING A PLURALITY OF SUCH CIRCUITS**
DATEN- UND TAKTRÜCKGEWINNUNGSSCHALTUNG UND EINE VORRICHTUNG MEHRERER DIESER SCHALTUNGEN ENTHALTEND
CIRCUIT DE RECUPERATION DE DONNEES ET D'HORLOGE ET DISPOSITIF COMPRENANT UNE PLURALITE DE CES CIRCUITS

(30) Priority: 16.08.2001 EP 01203121
(43) Date of publication of application: 18.08.2004
(73) Proprietor: Koninklijke Philips Electronics N.V., 5621 BA Eindhoven (NL)
(72) Inventor: SANDULEANU, Mihai, A., T., NL-5656 AA Eindhoven (NL)
(74) Representative: Duijvestijn, Adrianus Johannes
(86) International application number: PCT/IB2002/003229
(87) International publication number: WO 2003/017563

(56) References cited:
- WO-A-96/17435
- US-A- 5 446 416
- US-B1- 6 215 835
- TANOI S ET AL: "A 250-622 MHZ DESKEW AND JITTER-SUPPRESSED CLOCK BUFFER USING TWO-LOOP ARCHITECTURE" IEICE TRANSACTIONS ON ELECTRONICS, INSTITUTE OF ELECTRONICS INFORMATION AND COMM. ENG. TOKYO, JP, vol. E79-C, no. 7, 1 July 1996 (1996-07-01), pages 898-904, XP000632343 ISSN: 0916-8524

## Description

The invention relates to a Data and Clock Recovery circuit comprising an input for receiving a first signal having a first frequency within a first frequency range and a first phase, said Data and Clock Recovery circuit including an output for transmitting a first output signal having a second frequency and a second phase. The Data and Clock Recovery circuit further comprises a Phase Locked Loop coupled to the input.

The invention also relates to an arrangement comprising a plurality of data and clock recovery circuits.

Present date communication networks work at very high frequencies, using different transmission protocols. A continuous demand exists for increasing speed and capacity of the transmission lines such as e.g. radio channels or optical networks. In the same time the signal reception must be reliable no matter the transmission media and data protocol used. In order to obtain at the reception a "clean" signal, the receiver must provide, at least, a circuit for input signal reshaping and phase aligning, or as it is known, data recovery. With the increase of transmission frequencies it is desirable that the receiver has a re-timing property, too. The re-timing operation, also known as clock recovery, realizes the generation of a local clock frequency in order to synchronize with the incoming data and, in the same time, a phase alignment between the local clock and the incoming data. Furthermore, complex interconnected communication networks comprise a plurality of switches for redirecting the transmitted signals through different networks. It is desirable that the switches provide at least the re-timing of the transmitted signals for re-directing reliable signals. It is observed that when very high frequency signals are involved, e.g. tens of gigahertz (GHz), because of the parasitic components accompanying high frequency transmission lines e.g. inductances, capcitances and resistances the signal re-shape and the signal synchronization with the clock are necessary.

Normally, phase alignment is realized using a Phase Locked Loop (PLL) as in US-A-5, 608, 357. The data re-timing system described in the above mentioned patent comprises a Phase Locked Loop (PLL), said PLL comprising a phase detector coupled to a low-pass filter, said low-pass filter being further coupled to a master Voltage Controlled Oscillator (MVCO), the MVCO being coupled to the phase detector. The system uses a local clock coupled to the PLL, a signal obtained at an output of the low-pass filter being used to control a pair of slave VCO. The incoming data is inputted to the pair of slave VCO, the slave VCO generating a recovered clock frequency that is further used to re-timing input data with the recovered clock frequency. As it was previously mentioned, the input signal could have phase deviation because of the parasitic elements on the transmission line and, furthermore, it depends on temperature, humidity. When a fixed system clock is used, even when the PLL is used, the recovery information is not so reliable and the system is not flexible to adapt to the above mentioned influences.

US-A-5,446,416 discloses a time acquisition system having dual independent frequency and phase locked loops, each containing a dedicated voltage controlled oscillator (VCO). The frequency locked loop (FLL) outputs a frequency bias signal, used for coarse frequency lock-up, only when the difference frequency between the input signal and the FLL VCO is outside a predetermined frequency band -Δω_{L} to +Δω_{L}. Significantly, the frequency bias signal is equal to zero when the difference frequency between the input signal and the FLL VCO is inside the frequency band -Δω_{L} to +Δω_{L}. Hence, in this situation the circuit disclosed in D1 works with one loop i.e. the phase locked loop (PLL) and does not follow continuously the frequency variations of the input signal as that variations which may be generated by environmental determined parameters as temperature, humidity, delays due to the parasitic elements of the transmission line used for data transmission. The PLL provides a phase bias signal, used for fine tuning lock-up, when the difference frequency between the input signal and the PLL VCO is inside the predetermined frequency band -Δω_{L} to +Δω_{L}. Therefore, there is no interaction between loops during the final phase tuning lock-up. It is observed that an essential feature of is an adder 142, said adder combining the frequency bias signal and the phase bias signal and generating a control signal for the VCO included in the PLL. Hence, the VCO included in the PLL is controlled by both PLL and FLL bias signals. Furthermore, for small adjustments i.e. when the input signal is within a predefined range -Δω_{L} to +Δω_{L}, the circuits works only with one loop i.e. the PLL.

It is an object of the present invention to provide a data and clock recovery circuit suitable to be used in high frequency communication systems. It is another object of the invention to provide a data and clock recovery circuit adapting to the modifications due to environmental dependent parameters as temperature, humidity, delays due to the parasitic elements of the transmission line used for data transmission.

The invention is described by the independent claims. Dependent claims describe advantageous embodiments.

Because both the FLL and PLL are driven by the first input signal they adapt the second frequency and the second phase to any modification in the first signal due to an environmental parameter as temperature, humidity, delay due to the parasitic elements of a transmission line which is used for data transmission.

In an embodiment of the invention the FLL comprises a frequency detector receiving the first input signal and a second input signal having a third frequency, the frequency detector generating a second output signal indicative for a frequency difference between the first frequency and the third frequency. The FLL further comprises a master controlled oscillator having a first control input and a second control input and generating the second input signal under the control of a third input signal applied to the second control input. The FLL further comprises a first adaptation means coupled to the FD for generating a first adaptation signal that is indicative for the frequency difference between the first frequency and the third frequency, the first adaptation signal being suitable for an input of a first Low Pass Filter. A first Low Pass Filter is coupled to the Adaptation Means and generates the third input signal said third input signal being indicative for the frequency difference between the first frequency and the third frequency. A second Low Pass Filter is coupled to the first Low Pass Filter for further adapting the third input signal and transmitting the first control signal.

The master controlled oscillator has two control terminals for receiving control signals that could be voltages, currents, charges, optical signals. The control signal received at the first control input controls the fine tuning of the oscillator while the signal received at the second control terminal controls the coarse tuning of the oscillator. The oscillator generates the third input signal that is inputted in the frequency detector, said frequency detector further receiving the first input signal and generating the second output signal that could be a voltage, a current, a charge, an optical signal. The first adaptation means adapts the second output signal to the input of the first low pass filter. The first low pass filter eliminates high frequency harmonics from the second output signal and generates the third input signal which is a DC signal. The third input signal is further inputted to the second control input for controlling the coarse control of the master controlled oscillator, the signal being further inputted to the second low pass filter. The second low pass filter further filters the third input signal and modifies it's amplitude for generating the first control signal, said first control signal being a DC signal.

In an embodiment of the invention the Phase Locked Loop (PLL) comprises a phase detector receiving the first input signal and a first output signal, the phase detector generating a fourth output signal indicative for a phase difference between the first phase and the second phase. The PLL further comprises a slave controlled oscillator having a third control input and a fourth control input and generating the first output signal under the control of the first control signal applied to the third input and of a fourth input signal applied to the fourth control input. The PLL comprises a second adaptation means coupled to the phase detector for generating a second adaptation signal that is indicative for the phase difference between the first phase and the second phase, the second adaptation signal being suitable for an input of a third Low Pass Filter. The third Low Pass Filter is coupled to the phase detector and generates the fourth input signal, said fourth input signal being indicative for the phase difference between the first phase and the second phase.

The Phase Locked Loop (PLL) comprises the slave-controlled oscillator that could be substantially identical to the master controlled oscillator. The slave controlled oscillator has the third input for controlling it's coarse tuning and the fourth control input for controlling it's fine tuning. The first control signal is inputted to the third control input for controlling the coarse tuning of the slave-controlled oscillator. The fourth input signal generated by the third low pass filter is inputted to the fourth control input for the fine-tuning of the slave-controlled oscillator. The first output signal generated by the slave-controlled oscillator has substantially the same frequency as the second input voltage generated by the master controlled oscillator, being further substantially equal to the first frequency. The fourth output signal generated by the phase detector could be a voltage, a current, a charge, an optical signal and is inputted to the second adaptation means that adapts the fourth input signal to the input of the third low pass filter. The third low pass filter eliminates high frequency components from the fourth output signal and generates the fourth input signal that is a considerable DC signal.

In an embodiment of the invention the data and clock recovery circuit is comprised in an agile data and clock recovery circuit. The data and clock recovery circuit is coupled to a frequency adaptation means. The frequency adaptation means receives an input signal (In_S) within a second frequency range and transmits the first signal within the first frequency range under the control of a second control signal supplied at a fifth control input. The set of all possible first input signals is large enough according to data transmitting protocols and it is not reliable if not impossible to build the master control oscillator and the slave-controlled oscillator to have such a large oscillation range. In the same time it is desirable that the data and recovery circuit adapts to substantially all input signals having frequencies in different frequency ranges. That is why the data and clock recovery circuit is coupled to the frequency adaptation means. The frequency adaptation means converts the input signal having the second frequency range to the first signal having the first frequency range, under the control of the fifth control signal. The frequency adaptation means could be a prescaler, a frequency divider, a frequency multiplier, a frequency mixing circuit coupled to a band-pass filter. The second control signal could be a vector of digital signals controlling switches, oscillating frequencies generated by an additional oscillator.

It is another object of the invention to provide an arrangement comprising a plurality of such circuits coupled to a switching matrix for providing reliable signals which are redirected in an interconnected communication system.

In an embodiment of the invention an arrangement comprises an input protocol adaptation means for receiving an input vector of signals and for transmitting a first adapted-vector of signals to a switch matrix. The switch matrix selectively routes the elements of the first adapted vector of signals to an input of an output protocol adaptation means. The output protocol adaptation means generate an output vector of signals that is phase aligned to the input vector of signals. The input protocol adaptation means comprises a first plurality of input cells, at least one cell of the first plurality of input cells comprising either a data and clock recovery circuit as claimed in Claim 1 or an agile data and clock recovery circuit as claimed in Claim 11. Switch matrices are used to redirect input signals from an input to an output in a controllable manner. If signals with different frequency ranges are present simultaneously at different inputs of the switch matrix then the respective inputs must provide an agile data and clock recovery circuit for adapting to the respective frequency range and to recover both the clock and the data. Both the recovered data and the recovered clock are transmitted through the switch matrix. Because of possible parasitic phase shifts determined by the signals paths through the matrix a phase aligner must be provided at any output for maintaining the same phase relationship between the data and the clock of the signal.

If at the input of the switch matrix are presented signals with the same data rates then there is necessary only a data and clock recovery signal at one of the inputs. At all the remaining inputs there are provided only phase aligners for re-establishing the phase relation between the data and clock. The recovered clock is transmitted through the switch matrix together with the recovered data and as in the previously mentioned situation, a phase aligner must be provided at any output.

In a packet switching situation it is reliable to maintain only one data and clock recovery circuit at any input. The input signal passes through a phase alignement circuit that controls delays of the signal depending on a phase relation between the recovered clock and the input signal. At any output the signal transmitted from any input is passed again through a phase aligner for maintaining the phase relation between the recovered clock and the recovered data.

The above and other features and advantages of the invention will be apparent from the following description of exemplary embodiments of the invention with reference to the accompanying drawings, in which:
Fig. 1 depicts a block diagram of a Data and Clock Recovery circuit according to the invention,
Fig. 2 depicts a detailed description of the frequency locked loop and phase locked loop according to an embodiment of the invention,
Fig. 3 depicts block diagram of an agile data and clock recovery circuit according to an embodiment of the invention,
Fig. 4 depicts a communication arrangement according to an embodiment of the invention,
Fig. 5 depicts an input cell and an output cell for the communication arrangement when different data rates are presented at the inputs according to an embodiment of the invention,
Fig. 6 depicts input cells of the communication arrangement when data with the same rate is presented at the inputs according to an embodiment of the invention,
Fig. 7 depicts an input cell and an output cell for the communication arrangement when packet data is presented at the inputs according to an embodiment of the invention.

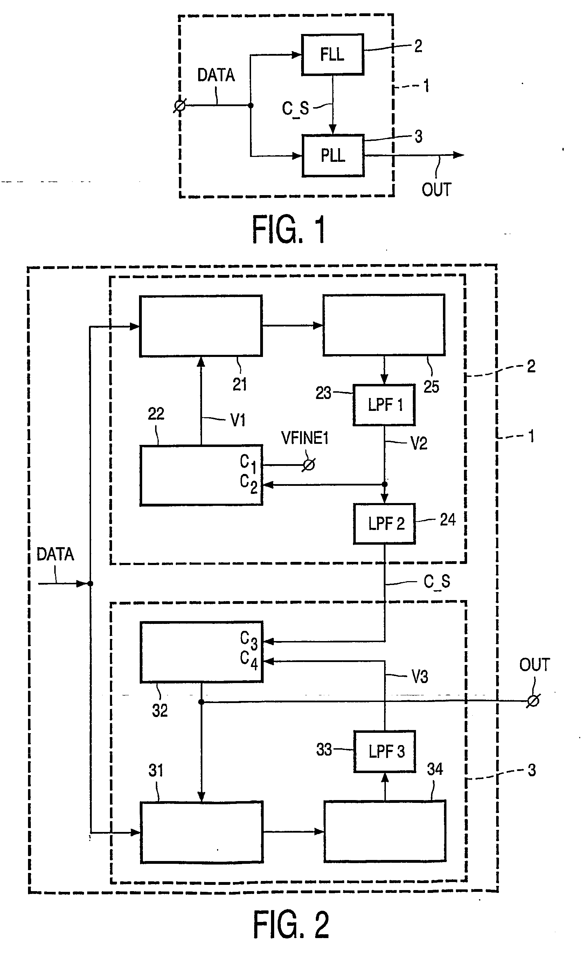

Fig. 1 depicts a block diagram of a Data and Clock Recovery (DCR) circuit 1 according to the invention. The DCR 1 comprises an input for receiving a first signal DATA having a first frequency within a first frequency range and a first phase. The said DCR circuit 1 comprises an output for transmitting a first output signal OUT having a second frequency and a second phase. The DCR 1 further comprises a Phase Locked Loop (PLL) 3 coupled to the input. The DCR 1 further comprises a Frequency Locked Loop (FLL) 2 coupled to the input for transmitting to the PLL 3 a first control signal C_S indicative for the first frequency i.e. for the frequency of DATA. The PLL 3 is conceived to transmit the output signal OUT under the control of the first control signal C_S, the output signal OUT having the second frequency substantially equal to the first frequency and the second phase substantially equal to the first phase. For example if DATA is a Non Return to Zero (NRZ) input signal then the FLL 2 recovers the information on frequency and generates the first control signal C_S that is indicative for the frequency. The control signal C_S is then used by the PLL 3 for minimizing the phase shifts between the DATA and the frequency, the output signal OUT having the frequency substantially equal to the frequency of the DATA and a minimum phase shift.

In a preferred embodiment the FLL 2 comprises a frequency detector 21 coupled to the input and further coupled to a Master Controlled Oscillator (MCO) 22, as it is shown in Fig. 2. The MCO 22 comprises a first control input C 1 and a second control input C2. A signal received on the first control input controls a fine tuning of the MCO 22. A third control signal V2 received at the second control input C2 controls a coarse tuning of the MCO 22. The control signals applied to the control inputs C1 and C2 could be voltages, currents, charges, optical signals. In a preferred embodiment the MCO is a Voltage Controlled Oscillator. The MCO 22 provides at it's output a second input signal V1, which is basically a periodical signal with a frequency controlled by the control signals received at the control inputs C 1 and C2. The signal V 1 is combined with the input signal DATA in the frequency detector 21. The frequency detector generates a signal that is representative for a frequency difference between the frequency of the DATA signal and the frequency of the second input signal V1. The signal generated by the frequency detector 21 is inputted into a first adaptation means 25 that adapts the signal to an input of a first Low Pass Filter (LPF) 23. For example if the input of the first LPF 23 is suitable for currents and the output signal of the frequency detector 21 is a voltage then the first adaptation means 25 could be a charge pump. The first Low Pass Filter 23 generates the third input signal V2, said third input signal V2 being indicative for the frequency difference between the first frequency and the third frequency. The first LPF 23 eliminates high frequency components of the signal received from the first adaptation means 25 and generates the third input signal that is essentially a DC one i.e. a variable signal comprising a constant component. A second Low Pass Filter (LPF) 24 is coupled to the first LPF 23. The second LPF 24 further eliminates high frequency components of the third control signal V2 and transmits the first control signal C_S that is essentially a DC signal. The LPF 24 adapts the first control signal C_S such that a slave controlled oscillator 32 comprised in the Phase Locked Loop 32 generates a periodical signal having a second frequency substantially equal to the first frequency.

The Phase Locked Loop (PLL) 32 comprises a phase detector 31 that receives the first input signal DATA for generating a fourth output signal OUT. The fourth output signal is indicative for a phase difference between the first phase i.e. the phase of DATA and the second phase i.e. the phase of OUT. The PLL 32 further comprises a Slave Controlled Oscillator (SCO) 32. The SCO 32 has a third control input C3 and a fourth control input C4. The first control signal C_S is inputted to the third control input C3 for controlling a coarse tuning of the SCO 32. A fourth input signal V3 inputted to the fourth control input controls a fine tuning of the SCO 32. In a preferred embodiment the first control signal C_S and the fourth control signal V3 are voltages and the SCO 32 is a voltage controlled oscillator but said control signals could be currents, charges, optical signals. The fourth output signal generated by the phase detector 31 is inputted to a second adaptation means 34. The second adaptation means 31 transmits a second adaptation signal to a third Low Pass Filter (LPF) 33. The second adaptation means 31 adapts the fourth output signal generated by the phase detector 31 to an input of the third LPF filter 33. For example if the input of the third LPF 33 is suitable for currents and the output signal of the phase detector 31 is a voltage then the second adaptation means 34 could be a charge pump. The third LPF 33 eliminates high frequency components of the second adaptation signal and generates the fourth input signal V3.

The first control signal C_S and the fourth input signal V3 determines an oscillation frequency of the SCO to be substantially equal to the first frequency i.e. the frequency of DATA. Said signals further determine that the second phase i.e. the phase of the signal OUT to substantially equal to the first phase i.e. the phase of DATA.

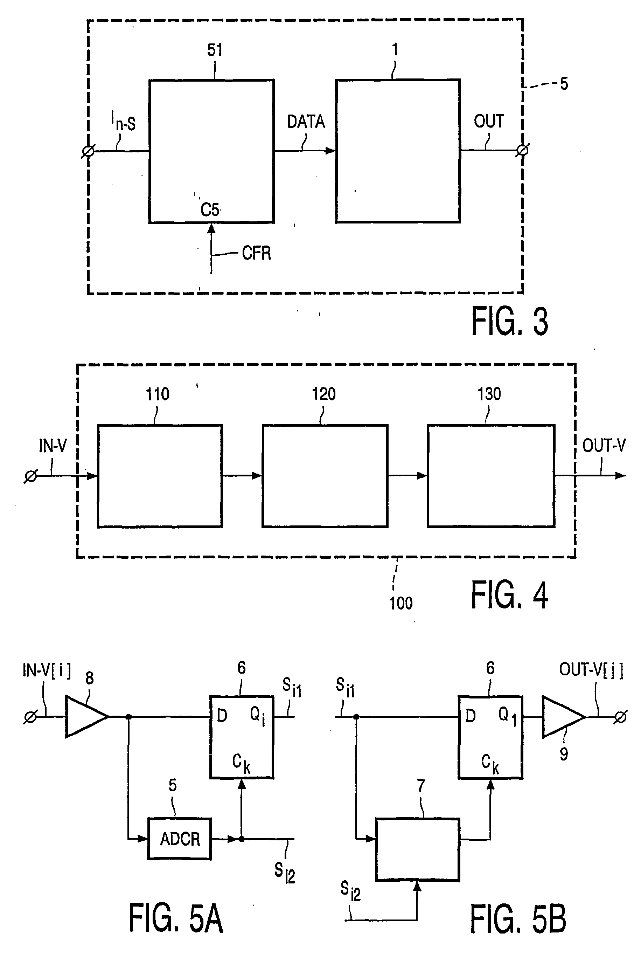

It should be pointed out here that it is desirable that the MCO 22 and the SCO 31 to be tunable within an as large as possible frequency range for recovering a broad spectrum of frequencies. In a preferred embodiment of the invention this feature is realized in an Agile Data and Clock Recovery (ADCR) circuit 5 as shown in Fig. 3. Said ADCR circuit 5 comprises the DCR circuit 1 coupled to a Frequency Adaptation Means (FAM) 51. The frequency adaptation means 51 converts an input signal InS having a second frequency range to the first signal DATA having the first frequency range, under the control of the fifth control signal CFR. The frequency adaptation means 51 could be a prescaler, a frequency divider, a frequency multiplier, a frequency mixing circuit coupled to a band-pass filter known per se in the technical literature. The second control signal CFR could be a vector of digital signals controlling switches, oscillating frequencies generated by an additional oscillator. The first output signal OUT has a frequency proportional to the frequency of the input signal In_S and the second phase proportional to a phase of the input signal In_S.

When data communication networks are considered, different signals are redirected using e.g. switch matrices. Switch matrices have n input terminals and m output terminals. A signal received at any input terminal is redirected to at least one of the output terminals. When relatively high frequency signals e.g. GigaHertz (Ghz) are involved, parasitic phase shifts and frequency deviations between the input signal in the switch matrix and the output signal appears. That is why it is desirable to minimize the parasitic phase shifts and frequency deviations and in the same time to adapt to different input signals transmitted according to different transmission protocols e.g. UMTS, CDMA.

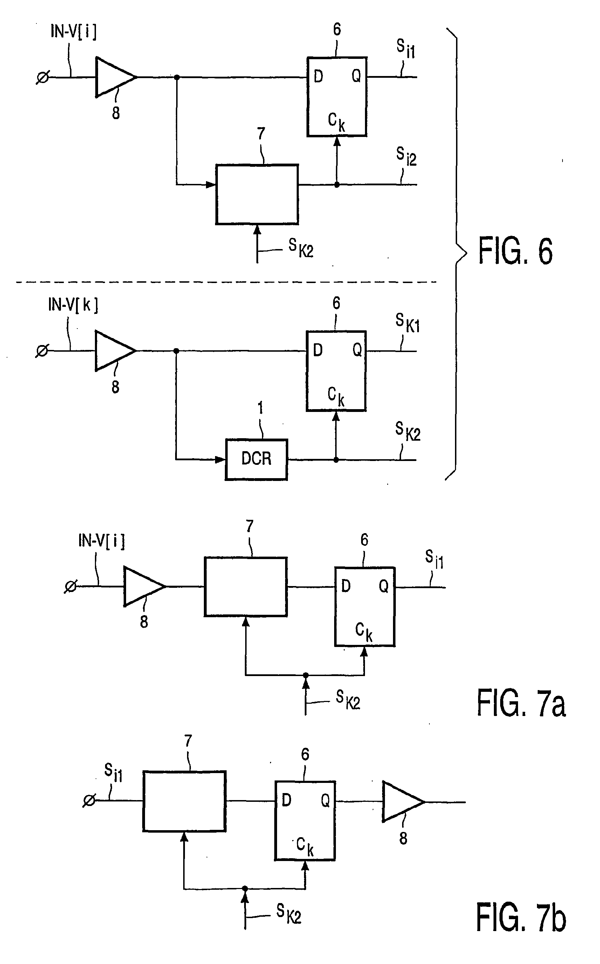

Fig. 4 depicts a communication arrangement 100 according to an embodiment of the invention. The arrangement 100 comprises an input protocol adaptation means 110 for receiving an input vector of signals IN_V and transmitting a first adapted vector of signals to a switch matrix 120. The switch matrix 120 selectively routes the elements of the first adapted vector of signals to an input of an output protocol adaptation means 130. The output protocol adaptation means 130 generates an output vector of signals that is phase aligned to the input vector of signals i.e. a phase shift between the said output vector of signals and the input vector of signals is substantially zero. The input protocol adaptation means comprises a first plurality of input cells, at least one cell of the first plurality of input cells comprising either a data and clock recovery circuit 1 or an agile data and clock recovery circuit 5. When signals with different frequency ranges are present simultaneously at different inputs of the switch matrix 120 then the respective inputs must provide an agile data and clock recovery (ADCR) circuit 5 for adapting to the respective frequency range. The ADCR circuit 5 recovers both the clock and the data as shown in Fig. 5. In Fig. 5a it is presented a cell e.g. having an index i of the input protocol adaptation means 110. In Fig. 5b it is presented an output cell e.g. having an index j of the output protocol adaptation means. The cell i comprises a buffer 8 coupled to an ADCR 5 and further coupled to a D type flip-flop 6. At an input terminal of the buffer 8 is applied an element of the input vector IN_V[i]. The buffer adapts the element IN_V[i] to an input of the ADCR circuit 5. At the output of the ADCR 5 is obtained a signal Si2 that is substantially in phase and has the frequency substantially equal to the frequency of the element IN_V[i]. The signal Si2 is used as a clock signal for the D flip-flop 6. At an output Q of the D flip-flop 6 it is obtained a signal Si1 that has to be transmitted through the switch matrix 120. Because different protocol signals could be present simultaneously at different inputs of the switch matrix 120 both the recovered data Si1 and the recovered clock should be transmitted. The signals Si1 and Si2 must be routed on similar ways i.e. ways with the same length in order to minimize the skew i.e. the propagation time difference through the switch matrix 120 between the signals Si1 and Si2 and preferably through parallel ways. It is still possible, especially when relatively high frequency signals are involved e.g. a few GHz, that small phase shifts between Si1 and Si2 appear. That is why a cell of the output protocol adaptation means 130 is like in Fig. 5b. Said cell of the output protocol adaptation means 130 comprises a phase aligner 7 that is controlled by the signal Si2. The phase aligner 7 receives the signal Si2 and generates a clock signal for a D flip-flop 6. The D flip-flop 6 receives the signal Si1 and generates a signal at an output Qₒ a signal that is substantially in phase with the signal Si2. The D flip-flop 6 is further coupled to an output buffer 9, said buffer transmitting a component of the, output vector OUT_V[j]. If the components of the input vector of signals have the same data rates then it is not necessary to have DCR 1 circuits at each of the input cells of the input protocol adaptation means 110. This situation is depicted in Fig. 6. In Fig. 6 an input cell of the input protocol adaptation means 110 e.g. k has the same configuration as in Fig. 5a and generates the signals Sk1 and Sk2 similar to the signals Si1 and Si2 respectively. All the other remaining cells of the input protocol adaptation means 110 do have the same configuration as that presented in Fig. 5b. Furthermore, any of the output cell of the output protocol adaptation means 130 do have the same configuration as in Fig. 5b.

In a packet switching situation it is reliable to maintain a data and clock recovery circuit 1 at a randomly chosen cell of the input protocol adaptation means 110, as shown in Fig. 6 and all the remaining cells of the input protocol adaptation means 110 to be as shown in Fig. 7a. The input signal passes through a phase alignement circuit that delays or speed-up the input signal IN_V[i] depending on a phase relation between the recovered clock Sk2 and the input signal IN_V[i]. At an output cell of the output protocol adaptation means 130 the signal transmitted from an input is passed again through a phase aligner 7 for maintaining the phase relation between the recovered clock Sk2 and the recovered data Si1 as shown in Fig. 7b.

It is remarked that the scope of protection of the invention is not restricted to the embodiments described herein. Neither is the scope of protection of the invention restricted by the reference numerals in the claims.

## Claims

1. A Data and Clock Recovery circuit (1) comprising:
- an input for receiving a first signal (DATA) having a first frequency within a first frequency range, and a first phase,
- an output for transmitting a first output signal (OUT) having a second frequency, substantially equal to the first frequency, and a second phase, substantially equal to the first phase,
- a Frequency Locked Loop (2) coupled to the input for generating a first control signal (C_S) indicative for the first frequency,
- the Frequency Locked Loop (2) comprising:
- a frequency detector (21) coupled to receive the first input signal (DATA) and a second input signal (V1) having a third frequency, for generating a second output signal indicative for a frequency difference between the first frequency and the third frequency,
- a master controlled oscillator (22) for generating the second input signal (V1) under the control of a third input signal (V2),
- a first Low Pass Filter (23) receiving the second output signal (V1) from the frequency detector (21) for generating the third input signal (V2), and
- a second low-pass filter (24) for receiving the third input signal (V2) and for generating the first control signal (C_S), and
- a Phase Locked Loop (3) comprising:
- a phase detector (31) coupled to receive the first input signal (DATA) and the first output signal (OUT) for generating a third output signal indicative for a phase difference between the first phase and the second phase,
- a slave controlled oscillator (32) for generating the first output signal (OUT) under the control of the first control signal (C_S), and
- a third Low Pass Filter (33) receiving the third output signal (V2) from the phase detector (31) for generating the fourth input signal (V3).

2. A Data and Clock Recovery circuit (1) as claimed in claim 1, wherein the third input signal (V2), the fourth input signal (V3) and the first control signal (C_S) are direct current signals.

3. A Data and Clock Recovery circuit (1) as claimed in claim 1, wherein the master controlled oscillator (22) is a quadrature oscillator.

4. A Data and Clock Recovery circuit (1) as claimed in claim 1, wherein the slave controlled oscillator (32) is a quadrature oscillator.

5. A Data and Clock Recovery circuit (1) as claimed in claim 1, wherein the frequency locked loop (2) having a first charge pump between the frequency detector (21) and the first low pass filter (33).

6. A Data and Clock Recovery circuit (1) as claimed in claim 1, wherein the Phase Locked Loop (3) comprises a second adaptation means (34) having a second charge pump between the phase detector (31) and the third low pass filter.

7. An Agile Data and Clock Recovery circuit (5) comprising a Data and Clock Recovery circuit (1) as claimed in any of claims 1 to 6, said Data and Clock Recovery circuit (1) being coupled to a frequency adaptation means (51), the frequency adaptation means receiving an input signal (In_S) within a second frequency range and transmitting the first signal (DATA) within the first frequency range under the control of a second control signal (CFR) supplied at a fifth control input (C5).

8. An arrangement (100) comprising an input protocol adaptation means (110) for receiving an input vector of signals (IN_V) and transmitting a first adapted vector of signals to a switch matrix (120) for selectively routing the elements of the first adapted vector of signals to an input of an output protocol adaptation means (130) for generating an output vector of signals (OUT_V) phase aligned to the input vector of signals (IN_V), said input protocol adaptation means (110) comprising a first plurality of input cells, at least one cell of the first plurality of input cells comprising either a data and clock recovery circuit (1), as claimed in claim 1 or an agile data and clock recovery circuit as claimed in claim 7.

## Patentansprüche

1. Daten- und Taktrückgewinnungsschaltung (1), die Folgendes umfasst:
- einen Eingang zum Empfangen eines ersten Signals (DATA) mit einer ersten Frequenz innerhalb eines ersten Frequenzbereichs und mit einer ersten Phase,
- einen Ausgang zum Übertragen eines ersten Ausgangssignals (OUT) mit einer zweiten, im Wesentlichen zur ersten Frequenz gleichen Frequenz und einer zweiten, im Wesentlichen zur ersten Phase gleichen Phase,
- einen an den Eingang gekoppelten Frequenzregelkreis (2) zum Erzeugen eines ersten Steuersignals (C_S), das auf die erste Frequenz schließen lässt,
- wobei der Frequenzregelkreis (2) Folgendes umfasst:
- einen Frequenzdetektor (21), der gekoppelt ist, das erste Eingangssignal (DATA) und ein zweites Eingangssignal (V1) mit einer dritten Frequenz zu empfangen, zum Erzeugen eines zweiten Ausgangssignals, das auf eine Frequenzdifferenz zwischen der ersten Frequenz und der dritten Frequenz schließen lässt,
- einen Master-gesteuerten Oszillator (22) zum Erzeugen des zweiten Eingangssignals (V1), gesteuert von einem dritten Eingangssignal (V2),
- ein erstes Tiefpassfilter (23), welches das zweite Ausgangssignal (V1) von dem Frequenzdetektor (21) empfängt, zum Erzeugen des dritten Eingangssignals (V2), und
- ein zweites Tiefpassfilter (24) zum Empfangen des dritten Eingangssignals (V2) und zum Erzeugen des ersten Steuersignals (C_S), und
- einen Phasenregelkreis (3), der Folgendes umfasst:
- einen Phasendetektor (31), der gekoppelt ist, das erste Eingangssignal (DATA) und das erste Ausgangssignal (OUT) zu empfangen, zum Erzeugen eines dritten Ausgangssignals, das auf eine Phasendifferenz zwischen der ersten Phase und der zweiten Phase schließen lässt,
- einen Slave-gesteuerten Oszillator (32) zum Erzeugen des ersten Ausgangssignals (OUT), gesteuert von dem ersten Steuersignal (C_S), und
- ein drittes Tiefpassfilter (33), welches das dritte Ausgangssignal (V2) von dem Phasendetektor (31) empfängt, zum Erzeugen des vierten Eingangssignals (V3).

2. Daten- und Taktrückgewinnungsschaltung (1) nach Anspruch 1, in der das dritte Eingangssignal (V2), das vierte Eingangssignal (V3) und das erste Steuersignal (C_S) Gleichstromsignale sind.

3. Daten- und Taktrückgewinnungsschaltung (1) nach Anspruch 1, in welcher der Master-gesteuerte Oszillator (22) ein Quadraturoszillator ist.

4. Daten- und Taktrückgewinnungsschaltung (1) nach Anspruch 1, in welcher der Slave-gesteuerte Oszillator (32) ein Quadraturoszillator ist.

5. Daten- und Taktrückgewinnungsschaltung (1) nach Anspruch 1, in welcher der Frequenzregelkreis (2) eine erste Ladungspumpe zwischen dem Frequenzdetektor (21) und dem ersten Tiefpassfilter (33) hat.

6. Daten- und Taktrückgewinnungsschaltung (1) nach Anspruch 1, in welcher der Phasenregelkreis (3) ein zweites Anpassungsmittel (34) mit einer zweiten Ladungspumpe zwischen dem Phasendetektor (31) und dem dritten Tiefpassfilter hat.

7. Agile Daten- und Taktrückgewinnungsschaltung (5) mit einer Daten- und Taktrückgewinnungsschaltung (1) nach Anspruch 1 bis 6, wobei die genannte Daten- und Taktrückgewinnungsschaltung (1) an ein Frequenzanpassungsmittel (51) gekoppelt ist, das Frequenzanpassungsmittel ein Eingangssignal (In_S) innerhalb eines zweiten Frequenzbereichs empfängt und das erste Signal (DATA), gesteuert von einem zweiten Steuersignal (CFR), das an einem fünften Steuereingang (C5) geliefert wird, innerhalb des ersten Frequenzbereichs überträgt.

8. Anordnung (100) mit einem Eingangsprotokoll-Anpassungsmittel (110) zum Empfangen eines Eingangsvektors von Signalen (IN_V) und Übertragen eines ersten angepassten Vektors von Signalen zu einer Schaltmatrix (120) zur selektiven Wegewahl für die Elemente des ersten angepassten Vektors von Signalen zu einem Eingang eines Ausgangsprotokoll-Anpassungsmittels (130) zum Erzeugen eines Ausgangsvektors von Signalen (OUT_V), die phasenabgeglichen mit dem Eingangsvektor von Signalen (IN_V) sind, wobei das genannte Eingangsprotokoll-Anpassungsmittel (110) eine erste Vielzahl von Zellen umfasst, wobei mindestens eine der Zellen der ersten Vielzahl von Eingangszellen entweder eine Daten- und Taktrückgewinnungsschaltung (1) nach Anspruch 1 oder eine Agile Daten- und Taktrückgewinnungsschaltung nach Anspruch 7 umfasst.

## Revendications

1. Circuit de récupération de Données et d'Horloge (1) comprenant :
- une entrée pour recevoir ùn premier signal (DATA) ayant une première fréquence se situant dans une première gamme de fréquences, et une première phase,
- une sortie pour transmettre un premier signal de sortie (OUT) ayant une deuxième fréquence sensiblement égale à la première fréquence, et une deuxième phase sensiblement égale à la première phase,
- une Boucle Verrouillée en Fréquence (2) reliée à l'entrée pour produire un premier signal de commande (C_S) représentatif de la première fréquence,
- la Boucle Verrouillée en Fréquence (2) comprenant :
- un détecteur de fréquence (21) relié de façon à recevoir le premier signal d'entrée (DATA) et un deuxième signal d'entrée (V1) ayant une troisième fréquence, pour produire un deuxième signal de sortie représentatif d'une différence de fréquence entre la première fréquence et la troisième fréquence,
- un oscillateur maître commandé (22) pour produire le deuxième signal d'entrée (V1) sous le contrôle d'un troisième signal d'entrée (V2),
- un premier Filtre Passe-Bas (23) recevant le deuxième signal de sortie (V1) du détecteur de fréquence (21) pour produire le troisième signal d'entrée (V2), et
- un deuxième Filtre Passe-Bas (24) pour recevoir le troisième signal d'entrée (V2) et pour produire le premier signal de commande (C_S), et
- une Boucle Verrouillée en Phase (3) comprenant :
- un détecteur de phase (31) relié de façon à recevoir le premier signal d'entrée (DATA) et le premier signal de sortie (OUT) afin de produire un troisième signal de sortie représentatif d'une différence de phase entre la première phase et la deuxième phase,
- un oscillateur esclave commandé (32) pour produire le premier signal de sortie (OUT) sous le contrôle du premier signal de commande (C_S), et
- un troisième Filtre Passe-Bas (33) recevant le troisième signal de sortie (V2) du détecteur de phase (31) pour produire le quatrième signal d'entrée (V3).

2. Circuit de Récupération de Données et d'Horloge (1) selon la revendication 1, **caractérisé en ce que** le troisième signal d'entrée (V2), le quatrième signal d'entrée (V3) et le premier signal de commande (C_S) sont des signaux continus.

3. Circuit de Récupération de Données et d'Horloge (1) selon la revendication 1, **caractérisé en ce que** l'oscillateur maître commandé (22) est un oscillateur en quadrature.

4. Circuit de Récupération de Données et d'Horloge (1) selon la revendication 1, **caractérisé en ce que** l'oscillateur esclave commandé (32) est un oscillateur en quadrature.

5. Circuit de Récupération de Données et d'Horloge (1) selon la revendication 1, **caractérisé en ce que** la boucle verrouillée en fréquence (2) a une pompe de charge entre le détecteur de fréquence (21) et le premier filtre passe-bas (33).

6. Circuit de Récupération de Données et d'Horloge (1) selon la revendication 1, **caractérisé en ce que** la Boucle Verrouillée en Phase (3) comprend des deuxièmes moyens d'adaptation (34) ayant une deuxième pompe de charge entre le détecteur de phase (31) et le troisième filtre passe-bas.

7. Circuit de Récupération Agile de Données et d'Horloge (5) comprenant un circuit de Récupération de Données et d'Horloge (1) selon l'une quelconque des revendications 1 à 6, ledit circuit de Récupération de Données et d'Horloge (1) étant relié à des moyens d'adaptation de fréquence (51), les moyens d'adaptation de fréquence recevant un signal d'entrée (In_S) se situant dans une deuxième gamme de fréquences et transmettant le premier signal (DATA) dans la première gamme de fréquences sous le contrôle d'un deuxième signal de commande (CFR) délivré sur une cinquième entrée de commande (C5).

8. Dispositif (100) comprenant des moyens d'adaptation de protocole d'entrée (110) pour recevoir un vecteur de signaux d'entrée (IN_V) et transmettre un premier vecteur de signaux adapté à une matrice de commutation (120) pour acheminer sélectivement à une entrée de moyens d'adaptation de protocole de sortie (130) les éléments du premier vecteur de signaux adapté pour générer un vecteur de signaux de sortie (OUT_V) aligné en phase sur le vecteur de signaux d'entrée (IN_V), lesdits moyens d'adaptation de protocole d'entrée (110) comprenant une première pluralité de cellules d'entrée, au moins une cellule de la première pluralité de cellules d'entrée comprenant soit un circuit de récupération de données et d'horloge (1) selon la revendication 1, soit un circuit de récupération agile de données et d'horloge selon la revendication 7.
